(19) Europäisches Patentamt
European Patent Office
Office européen des brevets

(11) Publication number: **0 390 565 A2**

(12) # EUROPEAN PATENT APPLICATION

(21) Application number: **90303371.0**

(51) Int. Cl.$^{5}$: **C08G 73/10, B32B 27/28**

(22) Date of filing: **29.03.90**

(30) Priority: **31.03.89 JP 80758/89**

(43) Date of publication of application:
**03.10.90 Bulletin 90/40**

(84) Designated Contracting States:
**AT BE CH DE DK ES FR GB GR IT LI LU NL SE**

(71) Applicant: **MITSUI PETROCHEMICAL INDUSTRIES, LTD.**
**2-5, Kasumigaseki 3-chome Chiyoda-ku**
**Tokyo 100(JP)**

(72) Inventor: **Kan, Kojiro, c/o Mitsui Petrochemical Ind. Ltd.**
**3, Chigusakaigan**
**Ichihara-shi, Chiba(JP)**
Inventor: **Kaneko, Isao c/o Mitsui Petrochemical Ind. Ltd.**
**1-2, Wagi 6-chome**
**Wagi-cho, Kuga-gun, Yamaguchi(JP)**

(74) Representative: **Myerscough, Philip Boyd et al**
**J.A.Kemp & Co. 14, South Square Gray's Inn**
**London, WC1R 5EU(GB)**

(54) **Imide prepolymers, cured products, method for making the same, laminate preparation, and encapsulating compositions.**

(57) A novel imide prepolymer comprising specific bismaleimide and diamine components in a specific molar ratio cures into a product having improved dielectric properties, heat resistance, and bond strength. An encapsulating composition for semiconductor packages is obtained therefrom. The prepolymer is used to form prepregs from which laminates useful as multilayer printed circuit boards are manufactured.

EP 0 390 565 A2

# Imide Prepolymers, Cured Products, Method for Making, Laminate Preparation, and Encapsulating Compositions

This invention relates to imide prepolymers exhibiting improved heat resistance, electrical properties, and bonding strength when cured. More particularly, it relates to imide prepolymers suitable as encapsulating compositions for multi-layer printed circuit boards and IC's as well as a method for making the same and their use.

## BACKGROUND OF THE INVENTION

An imide prepolymer comprising N,N′-4,4′-diphenylmethanebismaleimide and diaminodiphenylmethane is well known in the art as commercially available in the name of Kerimide (Nippon Polyimide K.K.). This resin has find applications in multi-layer printed circuit boards and the like because of moldability, workability, and heat resistance. Glass cloth laminates using the resin, however, can find limited applications because their delamination resistance and copper foil peel strength are low. Besides, to meet the recent demand for an increased computer operating speed and a higher wiring density, there is a strong need for a resin having improved electrical properties, typically a low dielectric constant.

## SUMMARY OF THE INVENTION

An object of the present invention is to provide a novel and improved imide prepolymer having improved electrical properties when cured and suitable for use in multi-layer printed circuit boards and as encapsulating, sealing, molding, casting or potting agents.

Another object of the present invention is to provide a method for making the imide prepolymer as well as its use.

In one form of the present invention, there is provided an imide prepolymer comprising a bismaleimide component and a diamine component in a molar ratio of bismaleimide component to diamine component of from 1.0 to 50.0. The bismaleimide component has formula (I):

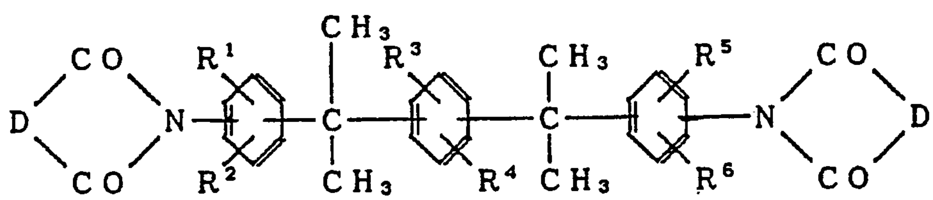

wherein D is a divalent group containing a carbon-to-carbon double bond, and $R^1$ through $R^6$ are independently selected from the class consisting of a hydrogen atom, an alkyl group having 1 to 5 carbon atoms, and a halogen atom. The diamine component has formula (II):

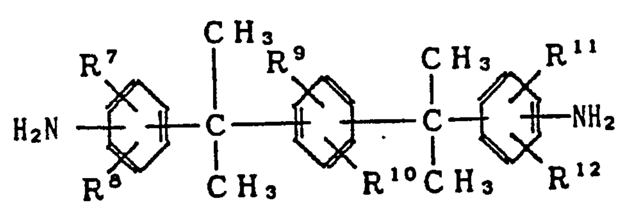

wherein $R^7$ to $R^{12}$ are independently selected from the class consisting of a hydrogen atom, an alkyl group having 1 to 5 carbon atoms, and a halogen atom.

A second form of the invention is a method for preparing an imide prepolymer comprising the step of

heat reacting a bismaleimide component of formula (I) with a diamine component of formula (II), formulae (I) and (II) being as defined above.

A third form of the invention is a method for preparing a laminate comprising the steps of:
dissolving an imide prepolymer as defined above in an inert solvent to form a varnish,
impregnating reinforcing fibers with the varnish,
drying the impregnated fibers to form prepregs,
stacking the prepregs, and
compression molding the prepreg stack under heat and pressure.

A fourth form of the invention is an encapsulating composition predominantly comprising an imide prepolymer as defined above.

Preferably, the bismaleimide component is of formula (III):

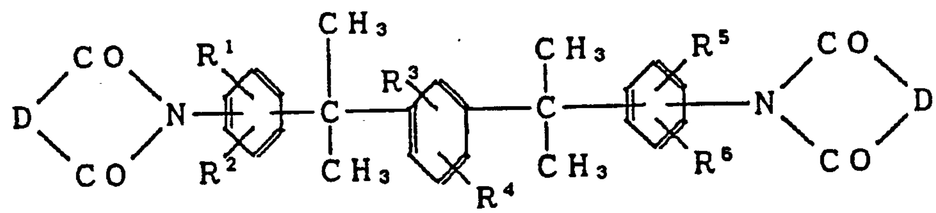

wherein D and $R^1$ through $R^6$ are as defined above.

## DETAILED DESCRIPTION OF THE INVENTION

The novel imide prepolymer of the invention contains at least units of a bismaleimide component of formula (I) and units of a diamine component of formula (II). The bismaleimide component used herein has formula (I):

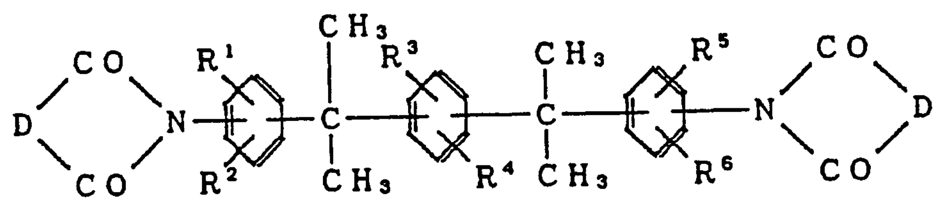

wherein D is a divalent group containing a carbon-to-carbon double bond, and $R^1$ through $R^6$ are independently selected from the class consisting of a hydrogen atom, an alkyl group having 1 to 5 carbon atoms, and a halogen atom. Some illustrative, non-limiting examples of the divalent group represented by D are given below.

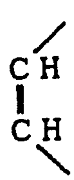 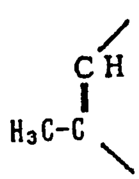 , 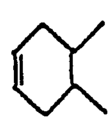 , 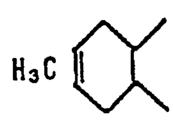

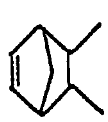 , 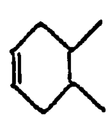 .

Substituents $R^1$ through $R^6$ are independently selected from the class consisting of a hydrogen atom, an alkyl group having 1 to 5 carbon atoms, and a halogen atom. They may be the same or different. The alkyl groups having 1 to 5 carbon atoms include methyl, ethyl, and isopropyl groups. The halogen atoms include bromo, chloro, and fluoro.

Some illustrative, non-limiting examples of the bismaleimide of formula (I) include:
α,α′-bis(N-4-maleimidophenyl)-m-diisopropylbenzene,
α,α′-bis(N-4-maleimidophenyl)-p-diisopropylbenzene,
α,α′-bis(N-4-maleimido-3-methylphenyl)-p-diisopropylbenzene,
α-α′bis(N-4-maleimido-3-methylphenyl)-m-diisopropylbenzene,
α,α′-bis(N-4-maleimido-3,5-dibromophenyl)-m-diisopropylbenzene α,α′-bis(N-4-maleimido-3,5-dibromophenyl)-p-diisopropylbenzene,
α,α′-bis(N-4-maleimidophenyl)-1,3-diisopropyl-5-methylbenzene,
α,α′-bis(N-4-maleimido-3,5-dibromophenyl)-1,3-diisopropyl-5-methylbenzene,
α,α′-bis(N-4-citraconimidophenyl)-m-diisopropylbenzene, and
α,α′-bis(N-4-citraconimidophenyl)-p-diisopropylbenzene.
A mixture of two or more of them is also useful. Preferred among them are α,α′-bis(N-4-maleimidophenyl)-m-diisopropylbenzene, α,α′-bis(N-4-maleimidophenyl)-p-diisopropylbenzene, α,α′-bis(N-4-maleimido-3-methylphenyl)-p-diisopropylbenzene, α,α′-bis(N-4-maleimido-3-methylphenyl)-m-diisopropylbenzene, α,α′-bis(N-4-maleimido-3,5-dibromophenyl)-m-diisopropylbenzene, and α,α′-bis(N-4-maleimido-3,5-dibromophenyl)-p-diisopropylbenzene.

The diamine component used herein has formula (II):

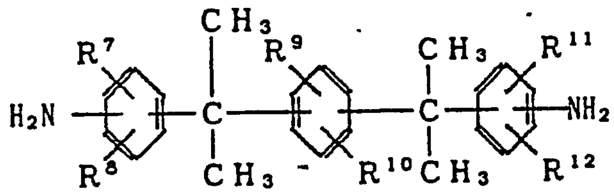

Substituents $R^7$ through $R^{12}$ are independently selected from the class consisting of a hydrogen atom, an alkyl group having 1 to 5 carbon atoms, and a halogen atom. They may be the same or different. The alkyl groups having 1 to 5 carbon atoms include methyl, ethyl, and isopropyl groups. The halogen atoms include bromo, chloro, and fluoro.

Some illustrative, non-limiting examples of the diamine of formula (II) include:
α,α′-bis(4-aminophenyl)-m-diisopropylbenzene,
α,α′-bis(4-aminophenyl)-p-diisopropylbenzene,
α,α′-bis(4-amino-3,5-dibromophenyl)-m-diisopropylbenzene,
α,α′-bis(4-amino-3-methylphenyl)-m-diisopropylbenzene,
α,α′-bis(4-amino-3-methylphenyl)-p-diisopropylbenzene,
α,α′-bis(4-aminophenyl)-1,3-diisopropyl-5-methylbenzene, and
α,α′-bis(4-amino-3,5-dibromophenyl)-1,3-diisopropylbenzene.
A mixture of two or more of them is also useful. Preferred among them are α,α′-bis(4-aminophenyl)-m-diisopropylbenzene and α,α′-bis(4-aminophenyl)-p-diisopropylbenzene.

The bismaleimide component of formula (I) and the diamine component of formula (II) are combined in such a proportion that the molar ratio of bismaleimide component of formula (I) to diamine component of formula (II) ranges from 1.0 to 50.0. An appropriate molar ratio may be selected in this range in accordance with the intended application of the imide prepolymer. The molar ratio of (I)/(II) preferably ranges from 1/1 to 10/1. Preferably, the molar ratio of (I)/(II) ranges from 1/1 to 5/1, more preferably from 1.5/1 to 3.5/1, most preferably from 2.5/1 to 3.5/1 because a cured product obtained by heat curing an imide prepolymer has high heat resistance as evidenced by glass transition temperature (Tg) and thermal decomposition temperature, and it also exhibits high bond strength, copper-foil peel strength, and delamination strength and a low dielectric constant as required for use as encapsulating composition and in copper-clad laminates.

The prepolymer of the invention generally has a number average molecular weight (Mn) of from about 550 to about 1,500, preferably from about 600 to about 1,000 and a weight average molecular weight (Mw) of from about 700 to about 3,500, preferably from about 800 to about 3,000.

Among the imide prepolymers of the invention, those imide prepolymers in which the bismaleimide component of formula (I) is an m-diisopropylbenzene bismaleimide of formula (III) are preferred because cured resin products resulting therefrom have a low dielectric constant. Formula (III)

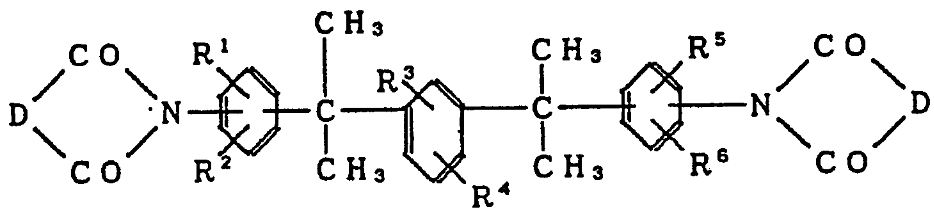

In formula (III), D is a divalent group containing a carbon-to-carbon double bond, and $R^1$ through $R^6$ are independently selected from the class consisting of a hydrogen atom, an alkyl group having 1 to 5 carbon atoms, and a halogen atom. Substituents D and $R^1$ through $R^6$ are as previously defined for formula (I).

Some illustrative, non-limiting examples of the bismaleimide of formula (III) include:
α,α′-bis(N-4-maleimidophenyl)-m-diisopropylbenzene,
α,α′-bis(N-4-maleimido-3-methylphenyl)-m-diisopropylbenzene,
α,α′-bis(N-4-maleimido-3,5-dibromophenyl)-m-diisopropylbenzene,
α,α′-bis(N-4-maleimidophenyl)-1,3-diisopropyl-5-methylbenzene,
α,α′-bis(N-4-maleimido-3,5-dibromophenyl)-1,3-diisopropyl-5-methylbenzene, and
α,α′-bis(N-4-citraconimidophenyl)-m-diisopropylbenzene.
A mixture of two or more of them is also useful. Preferred among them are α,α′-bis(N-4-maleimidophenyl)-m-diisopropylbenzene and α,α′-bis(N-4-maleimido-3-metylphenyl)-m-diisopropylbenzene.

In addition to the bismaleimide and diamine components, the imide prepolymer of the invention may contain a third component which does not alter the basic nature of the prepolymer, for example, a vinyl monomer such as triallylisocyanurate, triallyltrimellitate, m- or p-aminoisopropenylbenzene, styrene, allyl glycidyl ether, and methacrylic acid glycidyl ester, and a reactive monomer like an epoxy compound such as ethylene glycol diglycidyl ether. Further, the prepolymer of the invention may contain an epoxy resin, a reactive rubber component such as amine-terminated butadieneacrylonitrile rubber (ATBN), carboxyl-terminated butadieneacrylonitrile rubber, and epoxidized polybutadiene rubber, a silicone resin, a fluorocarbon resin, an aniline resin, a phenol resin or the like. These third components may be incorporated in the prepolymers in amounts of 5 to 100% by weight, preferably 10 to 50% by weight based on the total weight of the bismaleimide and diamine components.

The imide prepolymer of the invention may be prepared by mixing a bismaleimide compound of formula (I), a diamine compound of formula (II) and an optional component, and allowing them to react for several minutes to several hours at a temperature of 100°C to 250°C. Heat reaction may be carried out in solution form using a polar solvent such as dimethylformamide and N-methylpyrrolidone.

To control the reaction rate, catalysts such as radical scavengers, anionic polymerization catalysts, radical release agents, and Michael addition reaction accelerators may be used if desired.

Examples of the radical scavenger include stable radicals such as 1,1-diphenyl-2-picrylhydrazyl, 1,3,5-triphenylferdazyl, and 2,6-di-t-butyl-α-(3,5-di-t-butyl-4-oxo-2,5-cyclohexadien-1-ylidene-p-tolyloxy); phenol derivatives such as hydroquinone, 2,5-di-t-butylhydroquinone, t-butylcatechol, t-butylhydroquinone, and 2,5-di-t-butyl-4-methylphenol; benzoquinones such as benzoquinone, 2-methyl benzoquinone, and 2-chlorobenzoquinone; nitrosobenzene and its derivatives; nitrobenzenes such as nitrobenzene and m-dinitrobenzene; sulfur; and polyvalent metal salts such as iron (III) chloride; with hydroquinone, 2,5-di-t-butylhydroquinone, and 1,1-diphenyl-2-picrylhydrazyl being preferred. The radical scavenger may be used in an amount of 0.001 to 5% by weight based on the total weight of the bismaleimide and diamine compounds.

Examples of the anionic polymerization catalyst include imidazoles such as 2-methylimidazole, 2-ethyl-4-methylimidazole, 2-undecylimidazole, 2-phenylimidazole, 1-benzyl-2-methylimidazole, and 1-cyanoethyl-2-ethyl-4-methylimidazole; and tertiary amines such as triethylamine and benzyldimethylamine. Imidazoles are preferred catalysts, with 2-phenyl-4-methylimidazole and 1-benzyl-2-methylimidazole being most preferred.

Examples of the radical release agent include peroxides such as cumene hydroperoxide, t-butylhydroperoxide, dicumylperoxide, and di-t-butylperoxide; and azo compounds such as α,α′-azobisisobutyronitrile and azobiscyclohexanecarbonitrile.

Examples of the Michael addition reaction accelerator include aromatic monocarboxylic acids such as benzoic acid, o-toluic acid and its isomers, o-t-butylbenzoic acid and its isomers, o-chlorobenzoic acid and its isomers, o-dichlorobenzoic acid and its isomers, o-bromobenzoic acid and its isomers, o-nitrobenzoic acid and its isomers, o-hydroxybenzoic acid and its isomers, o-methoxybenzoic acid and its isomers, o-nitrobenzoic acid and its isomers, and o-aminobenzoic acid and its isomers; aromatic dicarboxylic acids such as phthalic acid and its isomers; tricarboxylic acids such as trimellitic acid; aromatic tetracarboxylic acids such as pyromellitic acid and benzophenonetetracarboxylic acid; aliphatic monocarboxylic acids such as formic acid, acetic acid, propionic acid, phenylacetic acid, silicic acid, glycolic acid, lactic acid, and tartaric acid; and aliphatic dicarboxylic acids such as malonic acid, succinic acid, glutaric acid, maleic acid, and fumaric acid. Also included are acid anhydrides such as maleic anhydride, tetrahydroxyphthalic anhydride, tetrahydroxymethylphthalic anhydride, nadic anhydride, trimellitic anhydride, pyromellitic anhydride, and 3,3′,4,4′-benzophenonetetracarboxylic dihydride. These carboxylic acids or anhydrides may be used in an amount of 0.01 to 5.0% by weight based on the total weight of the bismaleimide and diamine compounds of formulae (I) and (II).

The thus prepared prepolymer of the invention may be used in various forms. When reaction is carried out in a molten state, the reaction product may be used directly as reacted or after being finely divided into powder form or after being dissolved or suspended in a suitable solvent or medium to form a varnish. When reaction is carried out in a solution state, the reaction product may be used as a varnish in solution or suspension form without removing the solvent. Alternatively, the solvent is removed and the reaction product is finely divided into a powder form which may be used as such or after being dissolved again in a solvent to form a varnish. The solvents used herein are usually inert polar solvents such as N-dimethylformamide and N-methylpyrrolidone.

The prepolymers of the invention may be cured by heating to a temperature of about 180 to 250°C for about 10 to about 180 minutes, optionally under pressure. The cured products are infusible, insoluble, fully resistant against thermal strain, least hygroscopic, and stable against chemicals, and have excellent electrical properties.

The prepolymers of the invention may be blended with lubricants, release agents, coupling agents, and inorganic or organic fillers if desired.

Examples of the lubricant and release agent include carnauba wax and beeswax, fatty acid esters such as stearic acid butyl ester; fatty acid amides such as ethylene bisstearoamide; fatty acids such as stearic acid and montanic acid and metal salts thereof; petroleum wax, polyethylene wax, polypropylene wax and oxidized products thereof; and silicone fluids such as polymethylsiloxane and polymethylphenylsiloxane. Examples of the coupling agent include γ-glycidoxypropylmethoxysilane and N-β-(aminoethyl)-γ-aminopropyltrimethoxysilane. The lubricant, release agent or coupling agent may be added to the imide prepolymer in an amount of about 0.1 to 5% by weight based on the weight of the prepolymer.

Examples of the inorganic and organic fillers include silica powder, alumina powder, glass powder, mica, talc, barium sulfate, titanium oxide, molybdenum disulfide, aluminum powder, iron powder, copper powder, and metal hydroxides such as aluminum hydroxide and magnesium hydroxide; hollow balloons of silica, alumina, glass and phenol resin; and reinforcing fibers such as glass fibers, carbonized fibers, aramide fibers, alumina fibers, silicon carbide fibers, aluminum fibers, and copper fibers. The inorganic or organic filler may be added to the imide prepolymer in an amount of about 50 to 500% by weight based on the weight of the prepolymer.

Since the prepolymer of the invention cures into a product having improved electrical properties, heat resistance, and low water absorption, it is advantageously used as laminates such as printed circuit boards as well as IC encapsulating compositions, adhesives, and insulating varnishes.

A laminate may be prepared from the prepolymer of the invention by impregnating a mass or fabric of reinforcing fibers or a porous sheet with a solution of the prepolymer, followed by drying to form a prepreg. For example, a glass cloth is impregnated with a varnish containing the prepolymer and then dried to form a prepreg. Then a suitable number of thus prepared prepregs are stacked and heat pressed at a temperature of 180 to 250°C and a pressure of 10 to 40 $kgf/cm^2$ for about 20 to 180 minutes, obtaining a laminate having improved electrical properties, heat resistance, and low water absorption. The laminate may be used as prepared, but preferably after post-curing at a temperature of about 200 to 250°C for several hours to about 48 hours.

In addition, the imide prepolymers are advantageously used as encapsulating compositions for IC chips and LSI packages and the like. For this purpose, the encapsulating compositions may further contain a filler such as fused silica, a bonding agent such as silane coupling agent, a mold release agent such as wax and a curing agent such as an imidazole and a peroxide.

Preferably, the encapsulating compositions is prepared by mixing 150 to 400 parts by weight of the filler, 0.5 to 2 parts by weight of the mold release agent, 0.5 to 2 parts by weight of the bonding agent and 0.5 to 2 parts by weight of the curing agent with 100 parts by weight of the imide prepolymer.

The above described starting materials are preferably mixed at a temperature of 100 to 140°C for 1 to 10 minutes by rolls, molded at a temperature of 180 to 200°C for 2 to 10 minutes by a transfer molding

apparatus or the like and post cured for 5 to 24 hours at a temperature of 180 to 200° C.

## EXAMPLE

Examples of the invention are given below by way of illustration and not by way of limitation.

Prepolymers falling inside and outside the scope of the invention were prepared under the following conditions. Laminates were prepared by dissolving the prepolymer in a solvent to form a varnish, impregnating fibers with the varnish, drying the fibers to form a prepreg, and stacking such prepregs and copper foils. The laminates were evaluated for physical properties. In addition, cured plain resins and test specimens were prepared under the following conditions, then they were evaluated for physical properties.

### Evaluation test

(1) Copper foil peel strength

Copper foil peel strength was measured by peeling the copper foil according to JIS(Japanese Industrial Standard) C 6481.

(2) Delamination strength

Delamination strength was measured by separating away the adjacent prepreg layers under similar conditions to the copper foil peeling conditions.

(3) Glass transition temperature (Tg)

Tg of a sample was measured by using a tester (model TMA-100 manufactured by Seiko Electronic K.K.) and heating the sample at a rate of 10° C/min.

(4) Dielectric constant ($\epsilon$) and dielectric dissipation factor (tan$\delta$)

The dielectric constant and dielectric dissipation factor of a plate (of a cured plain resin as described in Example 1) were measured according to JIS K 6911 at a frequency of 1 MHz.

(5) Flexural strength

Flexural strength was measured according to JIS K 6911.

(6) Flexural modulus of elasticity

Flexural modulus of elasticity was measured according to JIS K 6911.

(7) Volume resistivity

Volume resistivity was measured according to JIS K 6911 at temperatures of 21° C and 150° C.

(8) Water absorption

A percent water absorption was determined by dipping a sample in distilled water at 125° C for 20 hours.

Example 1

A 1-liter flask was charged with 314.3 grams of α,α′-bis(N-4-maleimidophenyl)-m-diisopropylbenzene, 85.7 grams of α,α′-bis(4-aminophenyl)-p-diisopropylbenzene, and 400 grams of N-methylpyrrolidone. The molar ratio of bismaleimide to diamine was 2.5. Reaction was carried out for 5 hours at 120° C. The reaction solution formed a varnish, with which glass clothes (manufactured by NITTO BOSEKI K.K.) were impregnated and dried for 9 minutes at 160° C, obtaining prepregs having a resin content of 38% by weight. Nine prepregs thus prepared were stacked one on top of another, sandwiched between copper foils (manufactured by MITSUI KINZOKU KOGYO K.K.), placed in a press at 200° C, and compression molded under a pressure of 10 $kgf/cm^2$ for 60 minutes, obtaining a copper foil clad laminate. It was post cured at 200° C for 24 hours.

Separately, the varnish was poured into a large volume of water with stirring. The precipitated resin was collected by filtration. The resin was vacuum dried in a vacuum dryer for 8 hours at 60° C and then for 8 hours at 80° C. The resin was compression molded in a press at 200° C for 60 minutes, obtaining a plate of 2 mm thick. The plate was post cured at 200° C for 24 hours. This is designated a cured plain resin.

Example 2

The procedure of Example 1 was repeated except that α,α′-bis(N-4-maleimidophenyl)-p-diisopropylbenzene was used instead of α,α′-bis(N-4-maleimidophenyl)-m-diisopropylbenzene.

Example 3

The procedure of Example 1 was repeated except that α,α′-bis(4-aminophenyl)-m-diisopropylbenzene was used instead of α,α′-bis(4-aminophenyl)-p-diisopropylbenzene, reaction was carried out in an N-methylpyrrolidone solution at 120° C for 5 hours, and 1.2 grams of 1-benzyl-2-methylimidazole was then added to the reaction solution.

Comparative Example 1

A 1-liter flask was charged with 327.6 grams of N,N′-4,4′-diphenylmethanebismaleimide, 72.4 grams of 4,4′-diaminodiphenylmethane, and 400 grams of N-methylpyrrolidone. The molar ratio of bismaleimide to diamine was 2.5. By following the procedure of Example 1 thereafter, a glass cloth laminate and a plate were prepared.

Example 4

A 1-liter flask was charged with 314.3 grams of α,α′-bis(N-4-maleimidophenyl)-m-diisopropylbenzene and placed in an oil bath at 160° C to melt the charge. With stirring, 85.7 grams of α,α′-bis(4-aminophenyl)-p-diisopropylbenzene was added to the molten charge over about 1 minute (molar ratio = 2.5). Stirring was further continued, and the prepolymer was poured into a vat when 1 hour had passed since the start of addition of α,α′-bis(4-aminophenyl)-p-diisopropylbenzene. Immediately before taking out the prepolymer, 1.2 gram of 1-benzyl-2-methylimidazole in 5 grams of toluene was added thereto to obtain the curing accelerator-laden prepolymer.

The prepolymer was cooled down, finely divided, and then dissolved in N-methylpyrrolidone to prepare a varnish having a resin concentration of 50% by weight.

Glass clothes were impregnated with the varnish and dried for 9 minutes at 160° C, obtaining prepregs. Nine prepregs thus prepared were stacked one on top of another, sandwiched between copper foils, placed in a press at 200° C, and compression molded under a pressure of 10 $kgf/cm^2$ for 60 minutes, obtaining a copper clad laminate. It was post cured at 200° C for 24 hours.

Separately, the prepolymer was heated for 30 minutes in an air oven at 170 °C to promote reaction, taken out of the flask, cooled down, and finely divided. The prepolymer was compression molded in a press at 200 °C for 60 minutes, obtaining a plate of 2 mm thick. The plate was post cured in an air oven at 200 °C for 24 hours. This plate, designated a cured plain resin, was used for dielectric constant measurement.

Example 5

A prepolymer was synthesized by the same procedure as in Example 1 except that α,α′-bis(4-aminophenyl)-m-diisopropylbenzene was used instead of α,α′-bis(4-aminophenyl)-p-diisopropylbenzene. A copper clad laminate and a plate were prepared from the prepolymer by the same procedure as in Example 4.

Example 6

A flask was charged with 325.9 grams of α,α′-bis(N-4-maleimidophenyl)-m-diisopropylbenzene and the material was melted at 160 °C by immersing the flask in an oil bath. A copper foil clad laminate and a cured plain resin were prepared in the same manner as the procedure of Example 4 except that 74.1 grams of α,α′-bis(4-aminophenyl)-p-diisopropylbenzene was added to the melted bismaleimide gradually taking about 2 minutes with stirring. The molar ratio of bismaleimide to diamine was 3.0.

Example 7

A prepolymer was prepared in the same manner as the procedure of Example 6 except that α,α′-bis(4-aminophenyl)-m-diisopropylbenzene was used instead of α,α′-bis(4-aminophenyl)-p-diisopropylbenzene. Moldings were obtained from the prepolymer in the same manner as the process of Example 6.

Results of the evaluation of the products of Examples 1 to 7 and Comparative Example 1 are shown in Table 1.

Table 1

| | E1 | E2 | E3 | CE1 | E4 | E5 | E6 | E7 |
|---|---|---|---|---|---|---|---|---|
| Copper foil peel strength, kg/cm | 1.6 | 1.6 | 1.8 | 1.2 | 1.6 | 1.6 | 1.6 | 1.6 |
| Delamination strength, kg/cm | 1.7 | 1.5 | 1.8 | 0.9 | 1.7 | 1.7 | 1.7 | 1.7 |
| Tg, °C | 210 | 240 | 200 | 230 | 210 | 200 | 225 | 210 |
| ε* | 2.8 | 2.8 | 2.8 | 3.3 | 2.8 | 2.8 | 2.8 | 2.8 |
| tanδ* ($\times 10^{-4}$) | 30 | 32 | 28 | 78 | 30 | 32 | 18 | 20 |

* measured by a cured plain resin

Example 8

A 1-liter flask was charged with 325.9 grams of α,α′-bis(N-4-maleimidophenyl)-m-diisopropylbenzene and the material was melted at 160 °C by immersing the flask in an oil bath. To this was added 74.1 grams of α,α′-bis(4-aminophenyl)-p-diisopropylbenzene gradually taking about one minutes with stirring. The molar ratio of bismaleimide to diamine was 3.0. Stirring of the mixture was continued further for 1 hour. Thereafter, the reaction mixture was transferred on a tray and cooled spontaneously to room temperature, and the resultant solid material was ground to obtain a prepolymer. An encapsulating material was prepared by mixing 1 part by weight of γ-aminopropyltriethoxysilane, 233 parts by weight of fused silica, 1 part by weight of carnauba wax and 2 parts by weight of 2-methylimidazole with 100 parts by weight of the prepolymer, and by melt-kneading the mixture at 120 °C for 5 minutes using two rollers.

Test specimens for the evaluation of physical properties were prepared from the encapsulating material

by means of a transfer molding (190 °C, 20 kg/cm², 5 minutes), followed by post curing at 190 °C for 10 hours. Results of the evaluation is shown in Table 2.

Comparative Example 2

A prepolymer was prepared in the same manner as the procedure of Example 8 except that N,N′-4,4′-bismaleimidophenylmethane and diaminodiphenylmethane were used. An encapsulating material was prepared from the prepolymer using the same composition of Example 8 except that 1 part by weight of 2-methylimidazole was used. Test specimens were molded from the encapsulating material under the same conditions of Example 8. After post curing, physical properties of the specimen were evaluated. The results are shown in Table 2.

Table 2

| | Example 8 | Comparative Example 2 |
|---|---|---|
| Flexural strength 21 °C (kg/mm²) | 12 | 13 |
| Flexural modulus of elasticity 21 °C (kg/mm²) | 1400 | 1600 |
| Volume resistivity 21 °C | $1.3 \times 10^{16}$ | $1.4 \times 10^{16}$ |
| Ω•cm 150 °C | $4.5 \times 10^{14}$ | $3.5 \times 10^{14}$ |
| Water absorption (%) | 0.52 | 0.58 |
| Dielectric constant (1 MHz) | 3.3 | 3.5 |
| tan δ (1 MHz) | $1.2 \times 10^{-3}$ | $1.5 \times 10^{-3}$ |
| α'* (ppm/°C) | 16 | 16 |
| Tg | 220 °C | 240 °c |

* thermal coefficient of cubic expansion

The imide prepolymer of the invention cures into a product having improved electrical properties, heat resistance, and bond strength. A composition using the imide prepolymer is a useful encapsulating composition for IC chips and LSI packages. Laminates of prepregs obtained from the imide prepolymer are useful as multi-layer printed circuit boards because of increased copper foil peel strength and delamination strength.

Although some preferred embodiments have been described, many modifications and variations may be made thereto in the light of the above teachings. It is therefore to be understood that within the scope of the appended claims, the invention may be practiced otherwise than as specifically described.

**Claims**

1. An imide prepolymer comprising a bismaleimide component and a diamine component in a molar ratio of bismaleimide component to diamine component of from 1.0 to 50.0, said bismaleimide component being of formula (I):

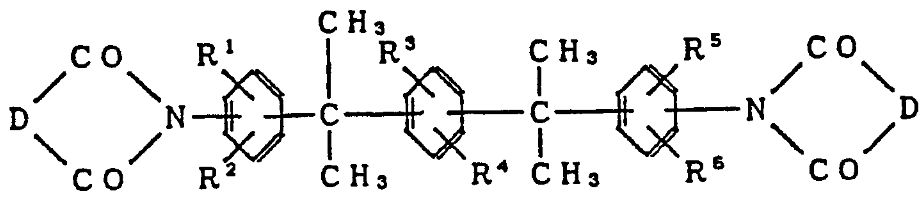

wherein D is a divalent group containing a carbon-to-carbon double bond, and $R^1$ to $R^6$ independently represent hydrogen, alkyl of 1 to 5 carbon atoms or halogen, and said diamine component being of formula (II):

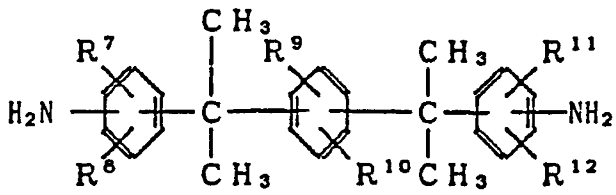

wherein $R^7$ to $R^{12}$ independently represent hydrogen, alkyl group of 1 to 5 carbon atoms or halogen.

2. An imide prepolymer according to claim 1 wherein said bismaleimide component is of formula (III):

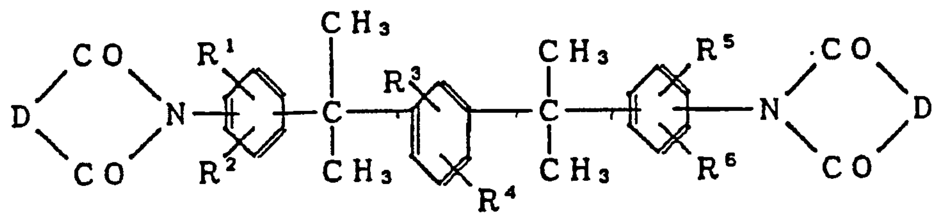

wherein D and $R^1$ and $R^6$ are as defined in claim 1.

3. A cured product obtained by heat curing an imide prepolymer as claimed in claim 1 or 2.

4. A method for preparing an imide as claimed in claim 1 or 2 which comprises heat reacting a bismaleimide component of formula (I) with a diamine component of formula (II).

5. A method for preparing a laminate which comprises dissolving an imide prepolymer as claimed in claim 1 or 2 in an inert solvent to form a varnish, impregnating reinforcing fibers with the varnish, drying the impregnated fibers to form prepregs, stacking the prepregs, and compression molding the prepreg stack under heat and pressure.

6. An encapsulating composition predominantly comprising an imide prepolymer as claimed in claim 1 or 2.